(19) 

Europäisches
Patentamt
European
Patent Office
Office européen
des brevets

(11)  **EP 3 202 748 A1**

(12)  **EUROPEAN PATENT APPLICATION**

(43) Date of publication:
09.08.2017  Bulletin 2017/32

(51) Int Cl.:
*C04B 35/468* (2006.01)   *H01L 41/187* (2006.01)
*H01C 7/02* (2006.01)

(21) Application number: 17155005.6

(22) Date of filing: 07.02.2017

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: 08.02.2016  JP 2016021460

(71) Applicant: **TDK Corporation
Tokyo 108-0023 (JP)**

(72) Inventors:
• **ITOH, Kazuhiko
Minato-ku, Tokyo 108-0023 (JP)**

• **SHIMURA, Yoshikazu
Minato-ku, Tokyo 108-0023 (JP)**
• **FUJITA, Kazutaka
Minato-ku, Tokyo 108-0023 (JP)**
• **MORIKOSHI, Hiroki
Minato-ku, Tokyo 108-0023 (JP)**
• **TERADA, Tomohiro
Minato-ku, Tokyo 108-0023 (JP)**

(74) Representative: **Epping - Hermann - Fischer
Patentanwaltsgesellschaft mbH
Schloßschmidstraße 5
80639 München (DE)**

(54)  **SEMICONDUCTOR CERAMIC COMPOSITION AND PTC THERMISTOR**

(57)   A semiconductor ceramic composition which is a $BaTiO_3$ based semiconductor ceramic composition, wherein, part of Ba is replaced by at least A (at least one alkali metal element selected from Na and K), Bi and RE (at least one element selected from rare earth elements including Y), and part of Ti is replaced by at least TM (at least one element selected from the group including of V, Nb and Ta), the relationships of $0.7\leq$ {(the content of Bi) / (the content of A)}$\leq 1.43$, $0.017\leq${(the content of Bi) + (the content of A)}$\leq 0.25$, and $0<$ {(the content of RE) + (the content of TM)}$\leq 0.01$ are satisfied when the total content of Ti and TM is set as 1mol, the grain sizes have a maximum peak in a grain size distribution in a range of $1.1\mu m$ to $4.0\mu m$ or less, and the distribution frequency of the peak is 20% or more.

Fig.1

EP 3 202 748 A1

**Description**

The present invention relates to a semiconductor ceramic composition and a PTC thermistor which are used in a heater element or an element for detecting overheats.

BACKGROUND

A PTC (Positive Temperature Coefficient) thermistor having positive temperature coefficient of resistance is known as one of the thermistors. The resistance in the PTC thermistor increases as the temperature rises, so the PTC thermistor is used as a self-controlling heater element, an over-current protection element, an element for detecting overheats or the like. In the past, the PTC thermistor was formed by adding a trace of rare earth based elements or the like into the main component of barium titanate ($BaTiO_3$) to turn it into a semiconductor. The resistance of the thermistor is low under a temperature below the Curie point; however, it will be sharply increased by several orders of magnitude under a temperature above the Curie point.

Usually, the Curie point of $BaTiO_3$ is about 120°C. When part of Ba is replaced by Sr or part of Ti is replaced by Sn, the Curie point can be shifted to a lower temperature. However, for shifting the Curie temperature towards a higher temperature, the current method is replacing part of Ba by Pb. Thus, an alternative material without using Pb is required to be applied from the viewpoint of the worldwide trend of reducing the environmental burden.

A semiconductor ceramic composition with a small resistivity at 25°C and a Curie point shifted to 130 to 183°C without using Pb is disclosed in the following Patent Document 1. The semiconductor ceramic composition can be obtained by replacing part of Ba in $BaTiO_3$ with Bi, alkali metal A1 (one or more selected from Na, K and Li) and rare earth element Q (one or more selected from La, Dy, Eu, and Gd) and adjusting the content of $(Bi_{0.5}A1_{0.5})$ and Q to specified ranges.

Patent Document

Patent Document 1: JP-B-4765258

SUMMARY

In the Patent Document 1, it has been described that a semiconductor ceramic composition with a small resistivity at 25°C can be obtained and its Curie point can be shifted to 130 to 183°C without using Pb. However, when the composition is considered to be used as a PTC thermistor, especially as a heater element, its withstand voltage or mechanical strength is likely to be not sufficient.

For example, the PTC thermistor used for interior heating in the vehicle functions as a heater element and is applied with a high voltage under the condition of being clamped by fin made of aluminum, so it is required to have an excellent mechanical strength and a high withstand voltage.

In view of the situations mentioned above, the present invention aims to provide a semiconductor ceramic composition whose Curie point is shifted to a temperature higher than 120°C and a PCT thermistor comprising the same, wherein the semiconductor ceramic composition has a small resistivity at 25°C and an excellent withstand voltage and mechanical strength.

The semiconductor ceramic composition is characterized in that part of Ba in the $BaTiO_3$ based semiconductor ceramic composition is replaced by at least A (at least one alkali metal element selected from the group consisting of Na and K), Bi and RE (at least one element selected from the group consisting of rare earth elements including Y), part of Ti is replaced by at least TM (at least one element selected from the group consisting of V, Nb and Ta); the inequations, i.e., $0.7 \leq \{$(the content of Bi)/(the content of A)$\} \leq 1.43$, $0.017 \leq \{$(the content of Bi) + (the content of A)$\} \leq 0.25$, and $0 < \{$(the content of RE) + (the content of TM)$\} \leq 0.01$, are satisfied when $\{$(the content of Ti) + (the content of TM)$\}$ is set as Imol; the semiconductor ceramic composition is composed of several crystal grains; the grain sizes of the several crystal grains have a maximum peak in the grain size distribution in the range of $1.1 \mu m$ or more and $4.0 \mu m$ or less, and the distribution frequency of the peak is 20% or more.

In addition, the PCT thermistor according to the present invention is characterized in that a pair of electrodes is formed on the surface of a ceramic body formed by using the above semiconductor ceramic composition.

According to the present invention, a semiconductor ceramic composition whose Curie point is shifted to a temperature higher than 120°C and a PCT thermistor comprising the same can be provided, wherein the semiconductor ceramic composition has a small resistivity at 25°C and an excellent withstand voltage and mechanical strength.

BRIEF DESCRIPTION OF THE DRAWINGS

Figure 1 is a perspective view showing a structure of the PTC thermistor comprising the semiconductor ceramic composition according to one embodiment of the present invention.

Figure 2 is a view showing the grain size distribution of the semiconductor ceramic composition according to one embodiment of the present invention.

DETAILED DESCRIPTION OF EMBODIMENTS

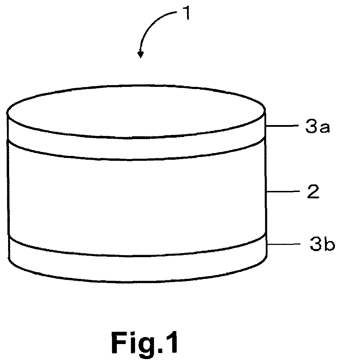

As shown in Figure 1, PTC thermistor 1 comprises ceramic body 2 which is composed of $BaTiO_3$ based semiconductor ceramic composition of the present invention, and a pair of electrodes 3a and 3b which is formed on the opposite surfaces of the ceramic body. The electrodes 3a and 3b can be formed with a single-layered structure or a multi-layered structure which is made of conducting materials such as Cu, Ni, Al, Cr, Zn, Ag, Ni-Cr alloy, Ni-Cu alloy, or the like.

The semiconductor ceramic composition according to one embodiment of the present invention can be any composition as long as it comprises the following composition, i.e., part of Ba of $BaTiO_3$ is replaced by Bi and A (at least one alkali metal element selected from the group consisting of Na and K), besides part of Ba is replaced by RE (at least one element selected from the group consisting of rare earth elements including Y) and part of Ti is replaced by TM (at least one element selected from the group consisting of V, Nb and Ta), wherein RE and TM are functioned as agents for semiconducting. For example, the composition is represented by the following formula (1).

$$(Ba_{1-b-c-e}Bi_bA_cRE_e)(Ti_{1-f}TM_f)O_3 \qquad (1)$$

In formula (1), b, c, e, and f preferably satisfy the following inequations (2) to (4), wherein b, c, e, and f respectively represent the amounts of Bi, A and RE to replace part of Ba site, and the amount of TM to replace part of Ti site.

$$0.7 \leq b/c \leq 1.43 \qquad (2)$$

$$0.017 \leq (b+c) \leq 0.25 \qquad (3)$$

$$0 \leq (e+f) \leq 0.01 \qquad (4)$$

In addition, the semiconductor ceramic composition is composed of several crystal grains. The grain sizes of the several crystal grains have a maximum peak in the grain size distribution in the range of $1.1\mu m$ or more and $4.0\mu m$ or less, and the distribution frequency of the peak is 20% or more.

The resistivity at 25°C is low, the withstand and the mechanical strength are high, and further the Curie point can be shifted to a temperature higher than 120°C by satisfying the above inequations (2) to (4), setting the range of the maximum peak of the grain size distribution to be $1.1\mu m$ or more and $4.0\mu m$ or less, and adjusting the distribution frequency of the peak to 20% or more. In addition, the Curie point of the present invention refers to the temperature, at which the resistivity of the semiconductor ceramic composition is twice as high as that at 25°C. The mentioned range of the maximum peak of the grain size distribution as well as the distribution frequency of the peak can be obtained by satisfying the above inequations (2) to (4) in formula (1) and properly adjusting the grain size of the raw material $TiO_2$ and the pulverization time in a ball mill after calcining process.

In addition, the grain size distribution of the crystal grains is achieved by image analysis from a scanning electron microscope image obtained by etching the polished cross-section with the semiconductor ceramic composition (sintered body) embedded. In particular, an image processing software, i.e., Mac-view, is used, the size of grains and the number is calculated by a scanning electron microscope, the grain size is regarded as Heywood diameter, and then the grain size distribution is calculated from the volume distribution. Further, the magnification in the scanning electron microscope image is set to have 50 or more grains.

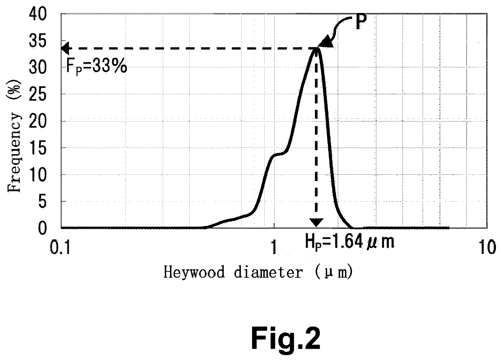

Figure 2 shows an example of the grain size distribution of the crystal grains obtained by the above mentioned method. Here, the maximum peak is the peak P when the frequency of the volume distribution relative to the Heywood diameter is obtained. At that time, when the Heywood diameter $H_P$ falls within the range of $1.1\mu m$ or more and $4.0\mu m$ or less and the frequency $F_P$ is 20% or more, a semiconductor ceramic composition with a low resistivity at 25°C and an excellent withstand voltage and mechanical strength. In the example shown in Figure 2, $H_P$ is $1.64\mu m$ and $F_P$ is 33%, which are within the above ranges.

Moreover, the range of the crystal grain size of the horizontal axis (i.e., Heywood diameter) is a default setting and is divided into 42 parts in the range of 0.005 to $6.541\mu m$.

In formula (1), the content b of Bi and the content c of A preferably satisfy $0.017 \leq (b+c) \leq 0.25$ and $0.7 \leq b/c \leq b1.43$ in terms of molar ratio when (Ti + TM) is set as 1mol. If (b+c) is less than 0.017, the Curie point will not be shifted to a temperature higher than 120°C, and thus it is not preferable. In addition, it is not preferred to render (b+c) higher than 0.25 because the ceramic composition will not completely become semiconductive and the resistivity at 25°C will increase. Further, in the case where $0.7 \leq b/c \leq 1.43$ is not satisfied, the ceramic composition will not completely become semiconductive and the resistivity at 25°C will increase, and thus it is not preferred.

In formula (1), RE (at least one element selected from rare earth elements including Y) and TM (at least one element selected from the group consisting of V, Nb and Ta) function as agents for semiconducting, and the total amount (e+f) of RE and TM preferably falls within the range, i.e., $0 \leq (e+f) \leq 0.01$. When (e+f) is 0 or higher than 0.01, the resistivity at 25°C will increase, and thus it is not preferred. More preferably, an effect of decreasing the resistivity at 25°C is large when the range is set to be 0.001 or more and 0.006 or less. Besides, RE or TM can be used alone as the agent for semiconducting, and the preferred additive amounts of RE and TM are the same. More preferably, RE is selected from the group consisting of La, Sm and Gd, and Nb is selected as TM. More preferably, RE (Sm, Gd, Er) and TM (Nb) are added in equal amounts. With such types of agents for semiconducting and adding methods, the effect on decreasing the resistivity at 25°C will be slightly improved.

In addition, the molar ratio of (the total molar number of Ba, Bi, A, and RE) to (the total molar number of Ti and TM) in the semiconductor ceramic composition more preferably satisfies 1.001 or more and 1.06 or less. Thus, the resistivity at 25°C can be further reduced.

In addition, it is preferable in the semiconductor ceramic composition that Ca is contained in a ratio of 0.049mol or less in terms of element when the total content of Ti and TM is set as 1mol. Thus, the sintered density will be enhanced and the resistivity at 25°C can be further reduced.

In addition, it is preferable in the semiconductor ceramic composition that Mn is contained in an amount of 0.003mol or less in terms of element when the total content of Ti and TM is set as 1mol. Thus, a proper acceptor level will be formed at the grain boundary so that PTC jump will be improved. However, if more than 0.003mol of Mn is contained, the trap for the conduction electrons will be excess so that the resistivity at 25°C tends to slightly increase. In addition, the PTC jump is an index for estimating the performance of the PTC thermistor, and it can be calculated from $\text{Log}_{10}$(resistivity at 280°C / resistivity at 25°C).

In addition, it is preferable in the semiconductor ceramic composition that Si is contained in an amount of 0.015mol or less in terms of element when the total content of Ti and TM is set as 1mol. Thus, the resistivity at 25°C can be further decreased. However, if more than 0.015mol of Si is contained, the excess element Si will segregate in a large quantity at the grain boundary so that the movement of conduction electrons will be inhibited and the resistivity at 25°C tends to be slightly deteriorated.

In addition, in the cases that the alkali metallic element A is Na or K, the shifting amounts of the Curie temperature towards a higher temperature are different, while the resistivities at 25°C or the withstand voltages and the mechanical strengths are the same.

The semiconductor ceramic composition of the present invention is obtained by mixing compounds which contain elements constituting the formula (1), calcining the mixture, pulverizing the calcined powder, adding binders to granulate and molding the powder, debinding and then sintering. The sintering process can be performed either in air or in a nitrogen atmosphere. However, when the sintering process is performed in a nitrogen atmosphere, an additional thermal treatment at 800 to 1000°C under an oxidative atmosphere is required. Thus, from the viewpoint of simple processes, the sintering process is preferred to be performed in air.

In addition, the present invention is not limited to the above embodiment. For example, in the semiconductor ceramic composition, the properties will not be influenced even when inevitable impurities are mixed as long as the following conditions are satisfied, i.e., part of Ba is replaced by at least A (at least one alkali metal element selected from the group consisting of Na and K), Bi and RE (at least one element selected from the group consisting of rare earth elements including Y); part of Ti is replaced by at least TM (at least one element selected from the group consisting of V, Nb and Ta); the inequations, i.e., $0.7 \leq \{(\text{the content of Bi})/(\text{the content of A})\} \leq 1.43$, $0.017 \leq \{(\text{the content of Bi}) + (\text{the content of A})\} \leq 0.25$, and $0 < \{(\text{the content of RE}) + (\text{the content of TM})\} \leq 0.01$, are satisfied when $\{(\text{the content of Ti}) + (\text{the content of TM})\}$ is set as Imol; a maximum peak of the grain size distribution is provided within the range of the grain size being $1.1\mu m$ or more and $4.0\mu m$ or less; and the distribution frequency of the peak is 20% or more. For example, zirconia ball is used as the grinding media during the wet mixing and pulverizing, and thus zirconia is likely to be mixed into the mixture with an amount of about 0.2 to 0.3 wt%, but it will not affect the properties of the composition. Similarly, Fe, Al, Sr and the like contained in the body materials with a trace amount of about 10wt ppm are likely to be mixed into the mixture, but they will not affect the properties of the composition especially.

Further, the semiconductor ceramic composition of the present embodiment may contain Pb as the impurity. However, the amount of Pb is preferably 1wt% or less, and it is more preferable that no Pb is contained. This is because the volatilization of Pb during the sintering process or the discharge of Pb into the environment after it is distributed in the market as a PTC thermistor and then abandoned can be inhibited to be a minimum, and the above amount of Pb is preferred from the viewpoint of low pollution, environmental friendliness and ecology.

EXAMPLES

Hereinafter, the present invention will be further described in detail based on Examples and Comparative Examples, but the present invention will not be limited to the following Examples.

[Example 1 (Samples No. 1 to 65) and Comparative Examples 1 to 20]

$BaCO_3$, $TiO_2$, $Bi_2O_3$, $Na_2CO_3$, $K_2CO_3$, $CaCO_3$, $SiO_2$, $MnCO_3$, the oxide of RE ( such as $Y_2O_3$), and the oxide of TM (such as $Nb_2O_5$) were prepared as the raw materials and then weighed to have the compositions as shown in Tables 1 to 7 after the sintering process. Next, the resultant mixture was subjected to a wet mixing process with acetone in a ball mill followed by a drying process and a calcining process at 900°C for 2 hours. Here, the particle size of the raw material $TiO_2$ will influence the grain particle size of the sintered body, thus, the raw material $TiO_2$ was used with an average particle size D50 of 0.7$\mu$m in the examples. In addition, the average particle size D50 of the raw material $TiO_2$ was obtained by using Microtrac MT3000II.

The calcined body was subjected to a wet pulverizing process in pure water by using a ball mill. Here, since the pulverization time with a ball mill would have an effect on the distribution frequency of the maximum peak of the grain size distribution of the sintered body, the pulverization time was set as 17 hours in the example. In addition, the average particle size D50 of the pulverized powder was 0.5 to 0.8$\mu$m. Here, the average particle size D50 of the pulverized powder was obtained by Microtrac MT3000II as the same way as that of the raw material $TiO_2$. After that, the mixture was dehydrated to dry and then granulated with binders such as polyvinyl alcohol to provide a granulated powder. The granulated powder was molded to have a plate shape ($\square$50mm $\times$ thickness of 2.5mm) with a uniaxial press machine and then sintered at 1200°C in air for 2 hours to provide a sintered body.

The two faces of the sintered body were polished to make the thickness be 1.5mm, and then the sintered body was cut by using a wet dicer into a strip with a size of 35mm $\times$ 6.5mm. The cut sintered body was measured to obtain a three-point bending strength according to JIS R 1601. Further, a paste of Ag-Zn was coated on both faces of the cut sintered body by screen printing, and the sintered body was baked at 500 to 700°C in air. After that, the temperature properties were measured from 25°C to 280°C. Further, the withstand voltage was measured. In addition, a maximum peak of the grain size distribution and a distribution frequency of the peak were obtained from the cross-section of the sintered body by the method mentioned above. The results of Example 1 of the present invention were shown in Tables 1 to 7.

[Example 2 (Samples No. 66 to 69) and Comparative Examples 21 to 24]

$BaCO_3$, $TiO_2$, $Bi_2O_3$, $Na_2CO_3$, and $Sm_2O_3$ were prepared as the raw materials and then weighed to have the composition as shown in Table 8 after the sintering process. Next, the resultant mixture was subjected to a wet mixing process with acetone in a ball mill followed by a drying process and a calcining process at 900°C for 2 hours. In addition, as shown in Table 8, several kinds of raw material $TiO_2$ with different average particle sizes D50 were used.

The calcined body was subjected to a wet pulverizing process in pure water by using a ball mill. Here, the pulverization time in the ball mill was changed as shown in Table 8. In addition, the average particle size D50 of the pulverized powder was 0.35 to 3.2$\mu$m. Except that, the same production method was used and the same assessment was performed as that of Example 1. The results of Example 2 of the present invention were shown in Table 8.

In addition, in the present invention, a low resistivity at 25°C referred to a resistivity of $10^3\Omega$cm or less. Similarly, a high withstand voltage referred to a withstand voltage of 300V/mm or more. Further, a high mechanical strength referred to a three-point bending strength of 100MPa or more.

It could be known from Table 1 that the total content (b+c) of the range b of Bi and the range c of A was related to the Curie temperature and the resistivity at 25°C. A represented at least one element selected from the group consisting of Na and K. Based on Samples No. 1 to 8, it could be seen that when (b+c) was 0.017 or more and 0.25 or less, the Curie point shifted to a temperature higher than the Curie temperature of barium titanate of 120°C, and the resistivity at 25°C was $10^3\Omega$cm or less. In Comparative Examples 1 and 3 where the range of (b+c) was less than 0.017, the resistivity at 25°C was small and the Curie point did not shift to a temperature higher than 120°C. In addition, in Comparative Examples 2 and 4 where the range of (b+c) was higher than 0.25, the resistivity at 25°C was found to exceed $10^3 \Omega cm$ to a great extent. Besides, when A was Na or K, the shifting amounts of the Curie point towards a higher temperature were different while the resistivity at 25°C was almost the same.

[Table 1]

| Sample No. | Grain size | | b [mol] | c [mol] | e (Sm) [mol] | f [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|
| | Maximum peak [μm] | Distribution frequency [%] | | | | | | | | | |
| Comparative Example 1 | 2.2 | 25 | 0.008 | 0.008 | 0.004 | 0 | 900 | 315 | 105 | 120 | Na |
| 1 | 2.2 | 26 | 0.009 | 0.008 | 0.004 | 0 | 620 | 318 | 106 | 125 | |
| 2 | 2.5 | 28 | 0.050 | 0.050 | 0.004 | 0 | 510 | 320 | 109 | 160 | |
| 3 | 1.8 | 25 | 0.100 | 0.100 | 0.004 | 0 | 750 | 312 | 111 | 200 | |
| 4 | 1.5 | 24 | 0.125 | 0.125 | 0.004 | 0 | 950 | 316 | 120 | 210 | |
| Comparative Example 2 | 1.5 | 22 | 0.130 | 0.130 | 0.004 | 0 | 1.0E+05 | - | 120 | - | |
| Comparative Example 3 | 2.0 | 28 | 0.008 | 0.008 | 0.004 | 0 | 900 | 330 | 110 | 120 | K |
| 5 | 1.9 | 27 | 0.009 | 0.008 | 0.004 | 0 | 650 | 330 | 110 | 125 | |
| 6 | 2.9 | 24 | 0.050 | 0.050 | 0.004 | 0 | 560 | 308 | 108 | 175 | |
| 7 | 3.2 | 22 | 0.100 | 0.100 | 0.004 | 0 | 770 | 306 | 102 | 210 | |
| 8 | 2.5 | 22 | 0.125 | 0.125 | 0.004 | 0 | 950 | 307 | 104 | 225 | |
| Comparative Example 4 | 1.9 | 21 | 0.130 | 0.130 | 0.004 | 0 | 1.0E+06 | - | 109 | - | |

EP 3 202 748 A1

In addition, according to Table 2, it could be known that the resistivity at 25°C was $10^3 \Omega$cm or less in Samples No. 4 and 9 to 11 in which the range b of Bi and the range c of A satisfied $0.7 \leq b/c \leq 1.43$. In Comparative Example 5 with the range being less than 0.07 or Comparative Example 6 with the range being higher than 1.43, the resistivity at 25°C was found to exceed $10^3 \Omega$cm to a great extent.

[Table 2]

| Sample No. | Grain size | | b+c [mol] | b/c | e (Sm) [mol] | f [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|
| | Maximum peak [μm] | Distribution frequency [%] | | | | | | | | | |
| Comparative Example 5 | 3.0 | 20 | 0.25 | 0.65 | 0.004 | 0 | 1.0E+05 | - | 100 | - | Na |
| 9 | 2.0 | 21 | 0.25 | 0.70 | 0.004 | 0 | 980 | 305 | 105 | 205 | |
| 4 | 1.5 | 24 | 0.25 | 1.00 | 0.004 | 0 | 950 | 316 | 120 | 210 | |
| 10 | 1.4 | 27 | 0.25 | 1.20 | 0.004 | 0 | 950 | 334 | 108 | 210 | |
| 11 | 1.2 | 29 | 0.25 | 1.43 | 0.004 | 0 | 965 | 340 | 119 | 210 | |
| Comparative Example 6 | 1.1 | 29 | 0.25 | 1.45 | 0.004 | 0 | 1.0E+04 | - | 119 | - | |

It could be known from Table 3 that the ratio (A/B) of (the total molar number of Ba, Bi, A, and RE) relative to (the total molar number of Ti and TM) had an influence on the resistivity at 25°C. In Sample No. 12 to 14 with the range of A/B being 1.001 or more and 1.06 or less, the resistivity at 25°C slightly reduced. However, if the range of A/B exceeded 1.06, the resistivity at 25°C trended to increase.

[Table 3]

| Sample No. | Grain size | | b [mol] | c [mol] | e (Sm) [mol] | f [mol] | A/B | Resistivity at 25°C [$\Omega$cm] | Withstand voltage [V/mm] | Three-point bending strength [MPa] | Tc [°C] | A Na or K |
|---|---|---|---|---|---|---|---|---|---|---|---|---|
| | Maximum peak [$\mu$m] | Distribution frequency [%] | | | | | | | | | | |
| 2 | 2.5 | 28 | 0.050 | 0.050 | 0.004 | 0 | 1.0 | 510 | 320 | 109 | 160 | Na |
| 12 | 2.5 | 28 | 0.050 | 0.050 | 0.004 | 0 | 1.001 | 480 | 320 | 110 | 160 | |
| 13 | 2.3 | 25 | 0.050 | 0.050 | 0.004 | 0 | 1.02 | 490 | 322 | 113 | 160 | |
| 14 | 1.5 | 26 | 0.050 | 0.050 | 0.004 | 0 | 1.06 | 510 | 330 | 119 | 160 | |

It could be known from Table 4 that the range of element Ca was related to the resistivity at 25°C. In Samples No. 15 to 17 where the content of Ca was 0.049mol or less, the resistivity at 25°C slightly decreased. However, if the content exceeded 0.049mol, the effect of decreasing the resistivity at 25°C trended to improve.

[Table 4]

| Sample No. | Grain size | | b [mol] | c [mol] | e (Sm) [mol] | f [mol] | Ca [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|---|
| | Maximum peak [μm] | Distribution frequency [%] | | | | | | | | | | |
| 2 | 2.5 | 28 | 0.050 | 0.050 | 0.004 | 0 | 0.0 | 510 | 320 | 109 | 160 | Na |
| 15 | 2.9 | 25 | 0.050 | 0.050 | 0.004 | 0 | 0.02 | 420 | 315 | 105 | 160 | |
| 16 | 2.7 | 24 | 0.050 | 0.050 | 0.004 | 0 | 0.035 | 480 | 308 | 104 | 160 | |
| 17 | 2.4 | 25 | 0.050 | 0.050 | 0.004 | 0 | 0.049 | 510 | 309 | 113 | 160 | |

It could be known from Samples No. 18 to 20 in Table 5 that an effect of decreasing the resistivity at 25°C would be provided if the range of sub-component Si was 0.015mol or less. However, if the range of Si was over 0.015mol, the resistivity at 25°C trended to increase.

[Table 5]

| Sample No. | Grain size | | b [mol] | c [mol] | e (Sm) [mol] | f [mol] | Si [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|---|
| | Maximum peak [μm] | Distribution frequency [%] | | | | | | | | | | |
| 2 | 2.5 | 28 | 0.050 | 0.050 | 0.004 | 0 | 0.0 | 510 | 320 | 109 | 160 | |
| 18 | 2.5 | 28 | 0.050 | 0.050 | 0.004 | 0 | 0.05 | 395 | 318 | 108 | 160 | Na |
| 19 | 2.6 | 25 | 0.050 | 0.050 | 0.004 | 0 | 0.01 | 490 | 325 | 111 | 160 | |
| 20 | 2.7 | 24 | 0.050 | 0.050 | 0.004 | 0 | 0.015 | 509 | 325 | 113 | 160 | |

It could be known from Samples No. 21 to 23 in Table 6 that as long as the range of Mn was 0.003mol or less, the more the amount was, the higher the PTC jump would be. However, if the range exceeded 0.003mol, the resistivity at 25°C trended to increase.

[Table 6]

| Sample No. | Grain size Maximum peak [μm] | Grain size Distribution frequency [%] | b [mol] | c [mol] | e (Sm) [mol] | f [mol] | Mn [mol] | Resistivity at 25°C [Ωcm] | Withstand voltage [V/mm] | Three-point bending strength [MPa] | PTC jump in 25 to 280°C [digit] | Tc [°C] | A Na or K |
|---|---|---|---|---|---|---|---|---|---|---|---|---|---|
| 2 | 2.5 | 28 | 0.050 | 0.050 | 0.004 | 0 | 0.0 | 510 | 320 | 109 | 3.6 | 160 | Na |
| 21 | 2.5 | 28 | 0.050 | 0.050 | 0.004 | 0 | 0.001 | 700 | 325 | 108 | 4.0 | 160 | |
| 22 | 2.3 | 26 | 0.050 | 0.050 | 0.004 | 0 | 0.002 | 850 | 330 | 105 | 4.3 | 160 | |
| 23 | 2.3 | 26 | 0.050 | 0.050 | 0.004 | 0 | 0.003 | 950 | 338 | 105 | 4.3 | 160 | |

It could be known from Samples No. 24 to 65 in Table 7 that if the total content (e+f) of RE and TM was 0.01 or less, the effect of decreasing the resistivity at 25°C would be provided. Further, it was more preferred to be 0.001mol or more and 0.006mol or less. In addition, RE was more preferred to be La, Sm or Gd, and TM was more preferred to be Nb. Besides, in Comparative Examples 7 to 20 where (e+f) was higher than 0.01, the resistivity at 25°C was found to exceed $10^3\Omega$cm. Further, it could be seen from Samples No. 60 to 65 that even if (e+f) was the same value, the case in which RE and RM was added with the same amount provided a small resistivity at 25°C.

[Table 7]

| Sample No. | Grain size | | b [mol] | c [mol] | RE | TM | e [mol] | f [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|---|---|
| | Maximum peak [μm] | Distribution frequency [%] | | | | | | | | | | | |
| Comparative Example 7 | 2.7 | 24 | 0.05 | 0.05 | - | - | 0 | 0 | 1.0E+05 | - | 104 | - | |
| 24 | 2.6 | 26 | 0.05 | 0.05 | Y | - | 0.001 | 0 | 750 | 315 | 104 | 160 | Na |
| 25 | 2.3 | 25 | 0.05 | 0.05 | | - | 0.006 | 0 | 600 | 310 | 109 | 160 | |
| 26 | 2.2 | 25 | 0.05 | 0.05 | | | 0.01 | 0 | 910 | 319 | 110 | 160 | |
| Comparative Example 8 | 2.6 | 26 | 0.05 | 0.05 | | - | 0.012 | 0 | 5.0E+03 | - | 105 | 160 | |
| 27 | 2.6 | 26 | 0.05 | 0.05 | La | - | 0.001 | 0 | 720 | 315 | 105 | 160 | Na |
| 28 | 2.3 | 25 | 0.05 | 0.05 | | - | 0.006 | 0 | 560 | 309 | 107 | 160 | |
| 29 | 2.1 | 28 | 0.05 | 0.05 | | - | 0.01 | 0 | 850 | 317 | 109 | 160 | |
| Comparative Example 9 | 2.0 | 27 | 0.05 | 0.05 | | - | 0.012 | 0 | 1.0E+04 | - | 109 | 160 | |
| 30 | 2.6 | 24 | 0.05 | 0.05 | Ce | - | 0.001 | 0 | 760 | 311 | 104 | 160 | Na |
| 31 | 2.3 | 25 | 0.05 | 0.05 | | - | 0.006 | 0 | 610 | 311 | 106 | 160 | |
| 32 | 2.1 | 26 | 0.05 | 0.05 | | - | 0.01 | 0 | 930 | 316 | 108 | 160 | |
| Comparative Example 10 | 2.1 | 26 | 0.05 | 0.05 | | - | 0.012 | 0 | 5.0E+03 | - | 108 | 160 | |
| 33 | 2.6 | 23 | 0.05 | 0.05 | Pr | - | 0.001 | 0 | 780 | 312 | 104 | 160 | Na |
| 34 | 2.2 | 24 | 0.05 | 0.05 | | - | 0.006 | 0 | 650 | 317 | 107 | 160 | |
| 35 | 2.0 | 25 | 0.05 | 0.05 | | - | 0.01 | 0 | 950 | 322 | 109 | 160 | |
| Comparative Example 11 | 2.0 | 25 | 0.05 | 0.05 | | - | 0.012 | 0 | 3.0E+03 | - | 109 | 160 | |

| Sample No. | Grain size | | b [mol] | c [mol] | RE | TM | e [mol] | f [mol] | Resistivity at 25°C [Ωcm] | Withstand voltage [V/mm] | Three-point bending strength [MPa] | Tc [°C] | A Na or K |
|---|---|---|---|---|---|---|---|---|---|---|---|---|---|
| | Maximum peak [μm] | Distribution frequency [%] | | | | | | | | | | | |
| 36 | 2.6 | 26 | 0.05 | 0.05 | Nd | - | 0.001 | 0 | 750 | 310 | 104 | 160 | Na |
| 37 | 2.1 | 23 | 0.05 | 0.05 | | - | 0.006 | 0 | 610 | 307 | 108 | 160 | |
| 38 | 2.0 | 23 | 0.05 | 0.05 | | - | 0.01 | 0 | 890 | 313 | 109 | 160 | |
| Comparative Example 12 | 2.0 | 23 | 0.05 | 0.05 | | - | 0.012 | 0 | 6.0E+03 | - | 109 | 160 | |
| 39 | 2.6 | 26 | 0.05 | 0.05 | Sm | - | 0.001 | 0 | 720 | 318 | 106 | 160 | Na |
| 40 | 2.5 | 27 | 0.05 | 0.05 | | - | 0.006 | 0 | 570 | 315 | 107 | 160 | |
| 41 | 2.0 | 28 | 0.05 | 0.05 | | - | 0.01 | 0 | 830 | 326 | 109 | 160 | |
| Comparative Example 13 | 2.0 | 28 | 0.05 | 0.05 | | - | 0.012 | 0 | 3.0E+03 | - | 109 | 160 | |
| 42 | 2.6 | 25 | 0.05 | 0.05 | | - | 0.001 | 0 | 710 | 315 | 105 | 160 | Na |
| 43 | 2.4 | 25 | 0.05 | 0.05 | | - | 0.006 | 0 | 580 | 313 | 109 | 160 | |
| 44 | 2.3 | 22 | 0.05 | 0.05 | | - | 0.01 | 0 | 860 | 322 | 110 | 160 | |
| Comparative Example 14 | 2.3 | 22 | 0.05 | 0.05 | | - | 0.012 | 0 | 3.0E+03 | - | 110 | 160 | |
| 45 | 2.6 | 26 | 0.05 | 0.05 | Dy | - | 0.001 | 0 | 800 | 313 | 103 | 160 | Na |
| 46 | 2.2 | 23 | 0.05 | 0.05 | | - | 0.006 | 0 | 660 | 308 | 106 | 160 | |
| 47 | 2.0 | 21 | 0.05 | 0.05 | | - | 0.01 | 0 | 950 | 317 | 108 | 160 | |
| Comparative Example 15 | 2.0 | 21 | 0.05 | 0.05 | | - | 0.012 | 0 | 6.0E+03 | - | 108 | 160 | |
| 48 | 2.6 | 26 | 0.05 | 0.05 | Er | - | 0.001 | 0 | 750 | 314 | 104 | 160 | Na |
| 49 | 2.2 | 24 | 0.05 | 0.05 | | - | 0.006 | 0 | 680 | 313 | 106 | 160 | |
| 50 | 2.0 | 23 | 0.05 | 0.05 | | - | 0.01 | 0 | 980 | 323 | 107 | 160 | |
| Comparative Example 16 | 2.0 | 23 | 0.05 | 0.05 | | - | 0.012 | 0 | 3.0E+03 | - | 107 | 160 | |

EP 3 202 748 A1

(continued)

| Sample No. | Grain size Maximum peak [μm] | Grain size Distribution frequency [%] | b [mol] | c [mol] | RE | TM | e [mol] | f [mol] | Resistivity at 25°C [Ωcm] | Withstand voltage [V/mm] | Three-point bending strength [MPa] | Tc [°C] | ANa or K |
|---|---|---|---|---|---|---|---|---|---|---|---|---|---|
| 51 | 2.5 | 26 | 0.05 | 0.05 | - | | 0 | 0.001 | 710 | 310 | 103 | 160 | |
| 52 | 2.0 | 23 | 0.05 | 0.05 | - | V | 0 | 0.006 | 650 | 312 | 110 | 160 | Na |
| 53 | 1.9 | 23 | 0.05 | 0.05 | - | | 0 | 0.01 | 940 | 315 | 111 | 160 | |
| Comparative Example 17 | 1.9 | 23 | 0.05 | 0.05 | - | | 0 | 0.012 | 1.0E+04 | - | 111 | 160 | |
| 54 | 2.5 | 26 | 0.05 | 0.05 | - | | 0 | 0.001 | 710 | 316 | 105 | 160 | |
| 55 | 2.3 | 25 | 0.05 | 0.05 | - | Nb | 0 | 0.006 | 560 | 319 | 110 | 160 | Na |
| 56 | 2.1 | 28 | 0.05 | 0.05 | - | | 0 | 0.01 | 810 | 322 | 111 | 160 | |
| Comparative Example 18 | 2.0 | 27 | 0.05 | 0.05 | - | | 0 | 0.012 | 3.0E+03 | - | 111 | 160 | |
| 57 | 2.5 | 25 | 0.05 | 0.05 | - | | 0 | 0.001 | 750 | 309 | 103 | 160 | |
| 58 | 2.0 | 23 | 0.05 | 0.05 | - | Ta | 0 | 0.005 | 700 | 309 | 107 | 160 | Na |
| 59 | 1.9 | 21 | 0.05 | 0.05 | - | | 0 | 0.01 | 980 | 312 | 108 | 160 | |
| Comparative Example 19 | 1.9 | 21 | 0.05 | 0.05 | - | | 0 | 0.012 | 7.0E+03 | - | 108 | 160 | |
| 60 | 2.5 | 25 | 0.05 | 0.05 | | | 0.003 | 0.003 | 550 | 315 | 106 | 160 | |
| 61 | 2.5 | 26 | 0.05 | 0.05 | Sm | Nb | 0.001 | 0.005 | 560 | 315 | 106 | 160 | Na |
| 62 | 2.4 | 26 | 0.05 | 0.05 | | | 0.005 | 0.001 | 560 | 315 | 105 | 160 | |
| 63 | 2.5 | 21 | 0.05 | 0.05 | | | 0.005 | 0.005 | 800 | 317 | 104 | 160 | |
| 64 | 2.4 | 21 | 0.05 | 0.05 | | | 0.002 | 0.008 | 820 | 317 | 104 | 160 | |
| 65 | 2.4 | 21 | 0.05 | 0.05 | | | 0.008 | 0.002 | 820 | 317 | 106 | 160 | |
| Comparative Example 20 | 1.9 | 18 | 0.05 | 0.05 | | | 0.006 | 0.006 | 1.0E+04 | | 106 | 160 | Na |

According to Table 8, the maximum peak of the grain size distribution was provided within the range of $1.1\mu m$ or more and $4.0\mu m$ or less, the distribution frequency of the peak was 20% or more, the withstand voltage was 300V/mm or more, and the three-point bending strength was 100MPa or more by properly adjusting the particle diameter of the raw material $TiO_2$ and the pulverization time of the ball mill in Samples No. 66 to 69. On the other hand, in Comparative Examples 21 and 24, the maximum peaks of the grain size distribution were out of the optimal range and the three-point bending strengths were all less than 100MPa through that the particle diameters of the raw material $TiO_2$ and the pulverization times in the ball mill were not properly adjusted. In addition, in Comparative Examples 22 and 23 where the particle diameters of the raw material $TiO_2$ and the pulverization times in the ball mill could not be properly adjusted, the maximum peaks of the grain size distribution fell within the range of $1.1\mu m$ or more and $4.0\mu m$ or less while the distribution frequencies of the peak were less than 20%, the withstand voltages were less than 300V/mm and the three-point bending strengths were less than 100MPa. The reason was considered that when the grain size distribution broadened, coarse grains would partly exist, which caused to the decrease of the withstand voltage or the three-point bending strength. In addition, when the maximum peak of the grain size distribution fell within the range of $1.1\mu m$ or more and $4.0\mu m$ or less, the resistivity at 25°C was almost the same.

[Table 8]

| Sample No. | Grain size distribution | | b [mol] | c [mol] | e (Sm) [mol] | f [mol] | Resistivity at 25°C [Ωcm] | Withstand voltage [V/mm] | Three-poin t bending strength [MPa] | Tc [°C] | A Na or K | D50 of the raw material TiO$_2$ [μm] | Pulverization time in ball mill (hour) |
|---|---|---|---|---|---|---|---|---|---|---|---|---|---|
| | Maximum peak [μm] | Distribution frequency [%] | | | | | | | | | | | |
| Comparative Example 21 | 0.9 | 30 | -0.050 | 0.050 | 0.003 | 0 | 600 | 305 | 95 | 160 | Na | 0.5μm | 20 |
| Comparative Example 22 | 1.1 | 18 | -0.050 | 0.050 | 0.003 | 0 | 550 | 290 | 98 | 160 | | 0.5μm | 5 |
| 66 | 1.1 | 20 | 0.050 | 0.050 | 0.003 | 0 | 530 | 304 | 103 | 160 | | 0.5μm | 10 |
| 67 | 2.5 | 25 | 0.050 | 0.050 | 0.003 | 0 | 500 | 312 | 107 | 160 | | 0.7μm | 15 |
| 68 | 2.5 | 30 | 0.050 | 0.050 | 0.003 | 0 | 510 | 348 | 110 | 160 | | 0.7μm | 20 |
| 69 | 4.0 | 20 | 0.050 | 0.050 | 0.003 | 0 | 490 | 302 | 101 | 160 | | 3.0μm | 10 |
| Comparative Example 23 | 4.0 | 18 | 0.050 | 0.050 | 0.003 | 0 | 490 | 292 | 95 | 160 | | 3.0μm | 5 |
| Comparative Example 24 | 4.2 | 22 | 0.050 | 0.050 | 0.003 | 0 | 470 | 280 | 95 | 160 | | 4.0μm | 10 |

DESCRIPTION OF REFERENCE NUMERALS

| 1 | PTC thermistor |
|---|---|
| 2 | ceramic body |
| 3a, 3b | electrode |

**Claims**

1. A semiconductor ceramic composition which is a $BaTiO_3$ based semiconductor ceramic composition, wherein, part of Ba is replaced by at least A, Bi and RE, and part of Ti is replaced by at least TM, wherein A represents at least one alkali metal element selected from the group consisting of Na and K, RE represents at least one element selected from rare earth elements including Y, and TM represents at least one element selected from the group consisting of V, Nb and Ta,
the relationships of $0.7\leq$ {(the content of Bi) / (the content of A)}$\leq 1.43$, $0.017\leq$ {(the content of Bi) + (the content of A)}$\leq 0.25$, and $0<$ {(the content of RE) + (the content of TM)}$<0.01$ are satisfied when the total content of Ti and TM is set as 1mol,
the semiconductor ceramic composition is composed of several crystal grains,
the grain sizes of the several crystal grains have a maximum peak in a grain size distribution in a range of $1.1\mu m$ or more and $4.0\mu m$ or less, and the distribution frequency of the peak is 20% or more.

2. A PTC thermistor comprising a ceramic body and a pair of electrodes formed on surfaces of the ceramic body, wherein, the ceramic body is formed by using the semiconductor ceramic composition of claim 1.

**Fig.1**

**Fig.2**

Europäisches
Patentamt

European
Patent Office

Office européen
des brevets

# EUROPEAN SEARCH REPORT

Application Number

EP 17 15 5005

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2005 255493 A (NEOMAX CO LTD) 22 September 2005 (2005-09-22) | 1,2 | INV. C04B35/468 H01L41/187 H01C7/02 |
| Y | * paragraphs [0001], [0028]; tables 1-7 * | 1,2 | |
| X | EP 2 067 755 A1 (MURATA MANUFACTURING CO [JP]) 10 June 2009 (2009-06-10) | 1,2 | |
| Y | * paragraph [0001]; tables 1,2 * | 1,2 | |
| X | US 2014/197156 A1 (INO KENTARO [JP] ET AL) 17 July 2014 (2014-07-17) | 1,2 | |
| Y | * paragraphs [0044], [0047], [0052]; tables 1-5 * | 1,2 | |
| X | EP 2 840 072 A1 (HITACHI METALS LTD [JP]) 25 February 2015 (2015-02-25) | 1,2 | |
| Y | * paragraphs [0001], [0063], [0069]; tables 1-6 * | 1,2 | |
| X | JP 2014 123603 A (HITACHI METALS LTD) 3 July 2014 (2014-07-03) | 1,2 | TECHNICAL FIELDS SEARCHED (IPC) |
| Y | * paragraphs [0001], [0025], [0027], [0032]; tables 1-10 * | 1,2 | C04B H01L H01C |
| Y | JP H08 191002 A (TEIKA CORP) 23 July 1996 (1996-07-23) * abstract * * paragraphs [0012] - [0014], [0032], [0042], [0047] * | 1,2 | |

The present search report has been drawn up for all claims

| Place of search | Date of completion of the search | Examiner |
|---|---|---|
| Munich | 7 June 2017 | Bonneau, Sébastien |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 15 5005

This annex lists the patent family members relating to the patent documents cited in the above-mentioned European search report.
The members are as contained in the European Patent Office EDP file on
The European Patent Office is in no way liable for these particulars which are merely given for the purpose of information.

07-06-2017

| Patent document cited in search report | | Publication date | Patent family member(s) | | Publication date |
|---|---|---|---|---|---|
| JP 2005255493 | A | 22-09-2005 | JP | 4765258 B2 | 07-09-2011 |
| | | | JP | 2005255493 A | 22-09-2005 |
| EP 2067755 | A1 | 10-06-2009 | CN | 101516802 A | 26-08-2009 |
| | | | EP | 2067755 A1 | 10-06-2009 |
| | | | JP | 5099011 B2 | 12-12-2012 |
| | | | KR | 20090045394 A | 07-05-2009 |
| | | | TW | 200835666 A | 01-09-2008 |
| | | | US | 2009201121 A1 | 13-08-2009 |
| | | | WO | 2008038538 A1 | 03-04-2008 |
| US 2014197156 | A1 | 17-07-2014 | CN | 103748056 A | 23-04-2014 |
| | | | EP | 2765122 A1 | 13-08-2014 |
| | | | JP | WO2013051486 A1 | 30-03-2015 |
| | | | KR | 20140089334 A | 14-07-2014 |
| | | | US | 2014197156 A1 | 17-07-2014 |
| | | | WO | 2013051486 A1 | 11-04-2013 |
| EP 2840072 | A1 | 25-02-2015 | CN | 104245625 A | 24-12-2014 |
| | | | CN | 104302599 A | 21-01-2015 |
| | | | EP | 2840072 A1 | 25-02-2015 |
| | | | EP | 2840073 A1 | 25-02-2015 |
| | | | JP | WO2013157649 A1 | 21-12-2015 |
| | | | JP | WO2013157650 A1 | 21-12-2015 |
| | | | US | 2015069308 A1 | 12-03-2015 |
| | | | US | 2015109094 A1 | 23-04-2015 |
| | | | WO | 2013157649 A1 | 24-10-2013 |
| | | | WO | 2013157650 A1 | 24-10-2013 |
| JP 2014123603 | A | 03-07-2014 | NONE | | |
| JP H08191002 | A | 23-07-1996 | NONE | | |

EPO FORM P0459

For more details about this annex : see Official Journal of the European Patent Office, No. 12/82

**EP 3 202 748 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4765258 B